# EUROPEAN PATENT APPLICATION

(11) **EP 4 412 408 A1**
(43) Date of publication of application: **07.08.2024**
(21) Application number: 22876060.9
(22) Date of filing: 22.09.2022
(51) Int. Cl.: H05K 1/14

(54) **WIRING BOARD**

(30) Priority: 29.09.2021 JP 2021159899
(71) Applicant: Kyocera Corporation, Kyoto-shi Kyoto 612-8501 (JP)
(72) Inventor: SAKURAI, Keizou, Kyoto-shi, Kyoto 612-8501 (JP)
(74) Representative: Viering, Jentschura & Partner mbB Patent- und Rechtsanwälte
(86) International application number: PCT/JP2022/035484
(87) International publication number: WO 2023/054193

(57) **Abstract**

A wiring board according to the present disclosure includes a base, a wiring conductor located on a surface of the base, a support body including a conductor on a surface thereof, and a first fixing member connecting the wiring conductor and the support body. The wiring conductor includes a first signal wiring conductor having a first region facing the support body and a second region extending continuously from the first region. The conductor of the support body includes a third region facing the first region of the first signal wiring conductor and a fourth region adjacent to the second region of the first signal wiring conductor. The first fixing member is located at a place other than the fourth region.

## Description

### TECHNICAL FIELD

The present invention relates to a wiring board.

### BACKGROUND OF INVENTION

In the related art, when connecting a wiring board and an electronic component such as a flip chip ball grid array (FCBGA) board or a large scale integration (LSI) each other, for example, as described in Patent Documents 1 and 2, the wiring board and the electronic component are connected to each other via a connection member (metal column). The connection member is connected to a terminal (pad) provided on the wiring board and a pad provided on the electronic component such that both end portions thereof are covered with metal such as solder.

For example, high-frequency signals (20 GHz or higher) are likely to be transmitted on a surface of a wiring conductor due to the skin effect. For this reason, in the case of a connection member connected to a signal wiring conductor, when an end portion of the connection member is covered with metal such as solder, high-frequency signals are likely to be reflected due to a difference in impedance between the signal wiring conductor and the metal such as solder. As a result, the high-frequency signals cannot be transmitted efficiently.

### CITATION LIST

### PATENT LITERATURE

Patent Document 1: JP 11-17309 A
Patent Document 2: JP 3344295 B

### SUMMARY

### SOLUTION TO PROBLEM

A wiring board according to the present disclosure includes a base, a wiring conductor located on a surface of the base, a support body including a conductor on a surface thereof, and a first fixing member connecting the wiring conductor and the support body. The wiring conductor includes a first signal wiring conductor having a first region facing the support body and a second region extending continuously from the first region. The conductor of the support body includes a third region facing the first region of the first signal wiring conductor and a fourth region adjacent to the second region of the first signal wiring conductor. The first fixing member is located at a place other than the fourth region. An electronic component mounting structure according to the present disclosure includes the wiring board and an electronic component.

### BRIEF DESCRIPTION OF THE DRAWINGS

FIG. 1 is an explanatory view for illustrating a main portion of an electronic component mounting structure including a wiring board according to one embodiment of the present disclosure.
FIG. 2 is an enlarged explanatory view for illustrating a region X illustrated in FIG. 1, as seen from an arrow A direction.
FIG. 3 is an enlarged explanatory view for illustrating another embodiment of the region X illustrated in FIG. 1, as seen from the arrow A direction.
FIG. 4 is an explanatory view for illustrating a variation of a support body.
FIG. 5 is an explanatory view for illustrating a variation of the support body.
FIG. 6 is an explanatory view for illustrating a variation of the support body.
FIG. 7 is an explanatory view for illustrating a variation of the support body.
FIG. 8 is an explanatory view for illustrating a variation of the support body.
FIG. 9 is an explanatory view for illustrating a variation of a first signal wiring conductor.
FIG. 10 is an explanatory view illustrating a state in which the support body and the first signal wiring conductor illustrated in FIG. 9 are connected to each other.
FIG. 11 is an explanatory view illustrating a state in which the support body and the first signal wiring conductor illustrated in FIG. 9 are separated from each other.
FIG. 12 is a graph showing a simulation result when the first signal wiring conductor and the support body illustrated in FIG. 10 are used.

### DESCRIPTION OF EMBODIMENTS

As described above, high-frequency signals (20 GHz or higher) are likely to be transmitted on a surface of a wiring conductor due to the skin effect. For this reason, in the case of a connection member connected to a signal wiring conductor, when an end portion of the connection member is covered with metal such as solder, high-frequency signals are likely to be reflected due to a difference in impedance between the signal wiring conductor and the metal such as solder. As a result, the high-frequency signals cannot be transmitted efficiently. Therefore, a wiring board has been needed that suppresses reflection of the high-frequency signals at a connection portion between the signal wiring conductor and the connection member and efficiently transmits the high-frequency signals.

In the wiring board according to the present disclosure, as described above, the first fixing member is located in a region other than the fourth region on the surface of the support body. That is, the fourth region adjacent to the second region of the first signal wiring conductor is not covered with the first fixing member. Therefore, the wiring board according to the present disclosure can suppress reflection of high-frequency signals at a connection portion between the signal wiring conductor and the connection member and efficiently transmit the high-frequency signals.

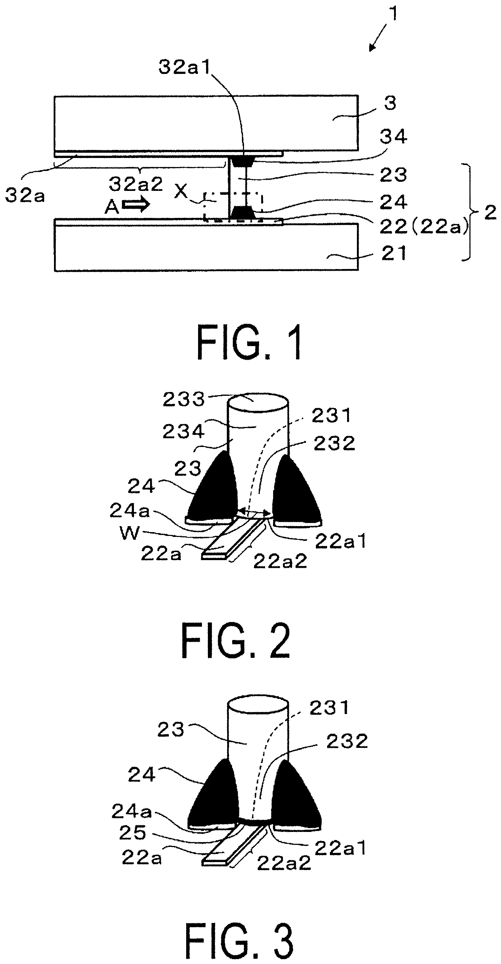

The wiring board according to the present disclosure will be described with reference to FIGs. 1 to 8. FIG. 1 is an explanatory view for illustrating a main portion of an electronic component mounting structure including a wiring board according to one embodiment of the present disclosure. A wiring board 2 according to one embodiment includes a base 21, a wiring conductor 22, a support body 23, and a first fixing member 24.

Although not illustrated specifically, the base 21 has a structure in which insulation layers and electrical conductor layers are alternately layered. The insulation layers included in the base 21 are made of a resin such as an epoxy resin, a bismaleimide-triazine resin, a polyimide resin, a polyphenylene ether resin, or a liquid crystal polymer. These resins may be used alone or in combination of two or more. Insulation particles may be dispersed in the insulation layers. The insulation particles are not limited, and examples thereof may include inorganic insulation fillers made of silica, alumina, barium sulfate, talc, clay, glass, calcium carbonate, titanium oxide, and the like, for example.

One of the plurality of insulation layers is a core layer and the remaining insulation layers are build-up insulation layers. The core layer has a thickness within a range from 0.05 mm to 2 mm, for example.

The core layer generally includes a through-hole conductor for electrically connecting the electrical conductor layers on upper and lower surfaces of the core layer. The through-hole conductor is located in a through-hole penetrating the upper and lower surfaces of the core layer. The through-hole conductor is formed of a part of the electrical conductor layers, for example. The through-hole conductor is connected to electrical conductor layers 4 on both surfaces of the core layer.

The build-up insulation layers each have a thickness within a range from 5 µm to 50 µm, for example. The build-up insulation layers may be made of the same resin or different resins.

The electrical conductor layers are located on main surfaces of the insulation layers, that is, on a main surface of the core layer and main surfaces of the build-up insulation layers. The electrical conductor layers are made of conductors such as copper, for example, copper foils or copper plating. A thickness of each of the electrical conductor layers is not particularly limited, and, for example, is within a range from 3 µm to 45 µm. When a plurality of electrical conductor layers are provided, the electrical conductor layers may be either the same electrical conductors or different electrical conductors.

Each of the build-up insulation layers includes a via hole conductor for electrically connecting the electrical conductor layers located above and below the build-up insulation layer. The via hole conductor is obtained by depositing, for example, copper plating, in a via hole penetrating the upper and lower surfaces of the build-up insulation layer. The via hole penetrating the upper and lower surfaces of the build-up insulation layer is formed by, for example, laser processing such as processing using a CO₂ laser, a UV-YAG laser, an excimer laser, or the like.

A wiring conductor 22 is located on a surface of the base 21. The wiring conductor 22 is a part of the above-described electrical conductor layer. The wiring conductor 22 includes a first signal wiring conductor 22a. As illustrated in FIG. 2, the first signal wiring conductor 22a includes a first region 22a1 and a second region 22a2 extending continuously from the first region 22a1. FIG. 2 is an enlarged explanatory view for illustrating a region X illustrated in FIG. 1, as seen from an arrow A direction.

The support body 23 is not limited as long as it has a form including a conductor on a surface thereof. That is, the support body 23 may be entirely formed of a conductor such as metal, or may have such a form that a conductor is located on a surface of an insulating member such as resin or ceramic.

As illustrated in FIG. 2, the conductor located on the surface of the support body 23 includes a third region 231 facing the first region 22a1 of the first signal wiring conductor 22a and a fourth region 232 adjacent to the second region 22a2 of the first signal wiring conductor 22a. In the present disclosure, regarding the fourth region 232 adjacent to the second region 22a2, the second region 22a2 and the fourth region 232 need not be adjacent to each other. That is, for example, as illustrated in FIG. 2, the fourth region 232 may be in contact with and adjacent to the second region 22a2, or as illustrated in FIG. 3 described below, the fourth region 232 may be adjacent to the second region 22a2 with a thin film layer 25 interposed therebetween. A relationship between a sixth region 32a2 and an eighth region 234, which will be described below, is the same as, and/or similar to, the relationship between the second region 22a2 and the fourth region 232.

The support body 23 is fixed to the wiring conductor 22 via the first fixing member 24. The first fixing member 24 is made of, for example, metal such as solder, gold, or silver. In the support body 23 connected to the first signal wiring conductor 22a, the first fixing member 24 is located at a place other than the fourth region 232 included on the surface of the support body 23. That is, the first fixing member 24 is not present from the second region 22a2 of the first signal wiring conductor 22a to the fourth region 232 included on the surface of the support body 23; thus, the regions are exposed. In this way, the first fixing member 24 is not present, so that reflection of high-frequency signals is suppressed and the high-frequency signals can be efficiently transmitted.

The fourth region 232 in which the first fixing member 24 as described above is not present is formed, for example, as follows. First, a resist film is formed in a region corresponding to the fourth region 232 of the support body 23 by applying or attaching a photosensitive ink or film to the support body 23 and performing exposure and developing processing. The fourth region 232 is formed by connecting the support body 23 to which the resist film is adhered and the base 21 each other via the first fixing member 24, and then removing the resist film with an aqueous solution (for example, a sodium hydroxide aqueous solution) or solvent in which the resist film is soluble.

The first fixing members 24 are preferably present at symmetrical positions with respect to the fourth region 232 in a plan view. The presence of the first fixing members 24 at symmetrical positions with respect to the fourth region 232 can help prevent the support body 23 from being pulled by the surface tension of the first fixing members 24 and being inclined.

A width of the fourth region 232 may be, for example, equal to or greater than 1/3 of a width of the second region 22a2. When the width of the fourth region 232 is equal to or greater than 1/3 of the width of the second region 22a2, reflection of high-frequency signals is sufficiently reduced, and the high-frequency signals can be transmitted more efficiently. The width of the fourth region 232 is preferably equal to or greater than the width of the second region 22a2. The width of the fourth region 232 can be defined as the shortest length (W indicated in FIG. 2) among lengths along a conductor surface connecting the first fixing members 24 between which the conductor of the support body 23 is sandwiched, in a direction parallel to an upper surface of the first signal wiring conductor 22a, for example.

As illustrated in FIG. 2, the first fixing member 24 may be located on a first fixing member pad 24a. In this case, the first fixing member pad 24a and the first region 22a1 of the first signal wiring conductor 22a are preferably located away from each other. When the first fixing member pad 24a and the first region 22a1 are located away from each other in this way, wetting and spreading of metal such as solder on the support body 23 can be reduced. The first fixing member pad 24a and the first region 22a1 may be connected to each other by a conductor having a width smaller than a width of the first fixing member pad 24a and a width of the first region 22a1. The width narrower than the width of the first fixing member pad 24a and the width of the first region 22a1 can be defined as a width smaller than both the largest width of the first fixing member pad 24a and the largest width of the first region 22a1 in an extension direction of the first signal wiring conductor 22a or in a direction perpendicular to the extension direction, for example.

As illustrated in FIG. 3, a thin film layer 25 may be located between the first region 22a1 of the first signal wiring conductor 22a and the third region 231 of the support body 23. When such a thin film layer 25 is, for example, an anti-rust film, oxidation of the conductors located in the first region 22a1 and the third region 231 can be reduced. The thin film layer 25 is, for example, a conductive material, is made of metal such as solder, gold, or silver, and has a thickness of 15 µm or less.

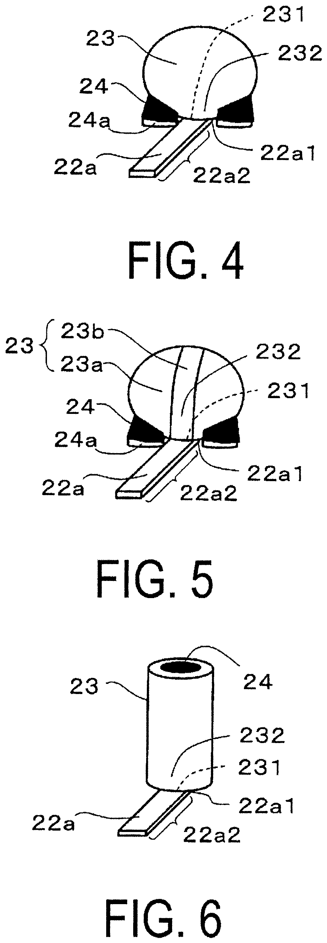

In FIGs. 2 and 3, the support body 23 has a cylindrical shape. The shape of the support body 23 is not limited as long as the support body 23 can be connected to and support an electronic component 3 described below when the electronic component 3 is mounted. Other than the cylindrical shape, the support body 23 may have a prismatic shape, or a spherical body, a tubular body, an annular body, or the like as illustrated in FIGs. 4 to 7. A height of the support body 23 is set to, for example, about 0.1 mm or greater and 2 mm or less, in consideration of a size of the wiring board 2 according to one embodiment, a size of an electronic component to be mounted, and the like.

As illustrated in FIGs. 4 and 5, when the support body 23 is a spherical body, the conductor may be located on at least a part of a surface thereof. Specifically, as illustrated in FIG. 4, the conductor may be located on the entire surface, or the spherical body itself may be a conductor such as metal. Alternatively, as illustrated in FIG. 5, the conductor may be located on a part of the surface of the spherical body. When the support body 23 is a spherical body as described above, a technology of mounting a solder ball (using a mask) on a ball grid array (BGA) board can be applied. As a result, the productivity of the wiring board 2 can be improved.

When the conductor is located on a part of the surface of the spherical body, the conductor is located such that signals are transmitted from the first signal wiring conductor 22a to the electronic component 3 to be mounted. Specifically, the conductor may be located so as to be in contact with the first signal wiring conductor 22a (that is, at the position of the fourth region 232). When the conductor is located on a part of the surface of the spherical body, a change in impedance can be further reduced.

When the conductor is located on a part of the surface of the spherical body, a width of the conductor is not limited. In such a case, the conductor preferably has a width of, for example, 70% or more and 130% or less of the width of the second region 22a2 of the first signal wiring conductor 22a. When the width of the conductor is within such a range, the change in impedance can be further reduced.

As illustrated in FIG. 6, when the support body 23 is a tubular body, the first fixing member 24 can be located in at least a part of a hollow portion of the support body 23. With such a configuration, the support body 23 can be fixed without exposing the first fixing member 24 on the surface of the support body 23. As a result, the change in impedance can be further reduced. Even in such an embodiment, in order to more firmly fix the support body 23, the first fixing member 24 may be further located at a place other than the fourth region 232 on the surface of the support body 23.

In a case where the support body 23 is a tubular body, a hole formed for venting air in the hollow portion at the time of manufacture may remain as it is. Such an air venting hole is formed, for example, in a region opposite to the fourth region 232.

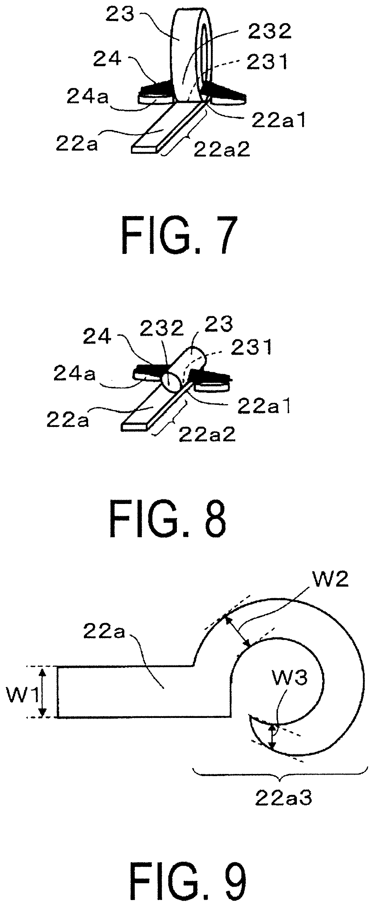

As illustrated in FIG. 7, when the support body 23 is an annular body, an outer peripheral surface of the annular body and the first signal wiring conductor 22a are fixed by the first fixing member 24. Specifically, the third region 231 located on the outer peripheral surface of the annular body is fixed by the first fixing member 24 so as to confront the first region 22a1 of the first signal wiring conductor 22a. The fourth region 232 is located on the outer peripheral surface of the support body 23 (annular body).

When the support body 23 is an annular body, the outer peripheral surface and the inner peripheral surface are surfaces, and a signal path can be secured on the outer peripheral surface and the inner peripheral surface. As a result, the high-frequency signals can be transmitted more efficiently.

When the support body 23 is a columnar body, as illustrated in FIG. 8, the columnar body may be fixed to the first signal wiring conductor 22a by the first fixing member 24 such that a height direction (longitudinal direction) of the columnar body is parallel to the extension direction of the first signal wiring conductor 22a. That is, the columnar body may be fixed to the first signal wiring conductor 22a in a state in which the columnar body is laid down. Since the wiring board 2 has such a structure, the accuracy in the height direction can be improved, and the support body 23 is less likely to fall down, making it possible to further improve the reliability. The wiring board 2 having such a structure can be easily manufactured and the productivity can be improved.

For example, when the support body 23 is a spherical body as illustrated in FIGs. 4 and 5, the first signal wiring conductor 22a as illustrated in FIG. 9 may be adopted. FIG. 9 is an explanatory view for illustrating a variation of the first signal wiring conductor 22a. The first signal wiring conductor 22a illustrated in FIG. 9 has a hook-shaped portion 22a3 at a portion that is connected to the support body 23.

In the first signal wiring conductor 22a illustrated in FIG. 9, a width of the hook-shaped portion 22a3 decreases toward a distal end thereof. For example, as illustrated in FIG. 9, a width of a portion of the first signal wiring conductor 22a other than the hook-shaped portion 22a3 is W1. The width W1 is usually equal to a width W2 of a root of the hook-shaped portion 22a3 or wider than the width W2 of the root of the hook-shaped portion 22a3. In the hook-shaped portion 22a3, the width W2 of the root is larger than a width W3 of the distal end and becomes smaller from the root to the distal end.

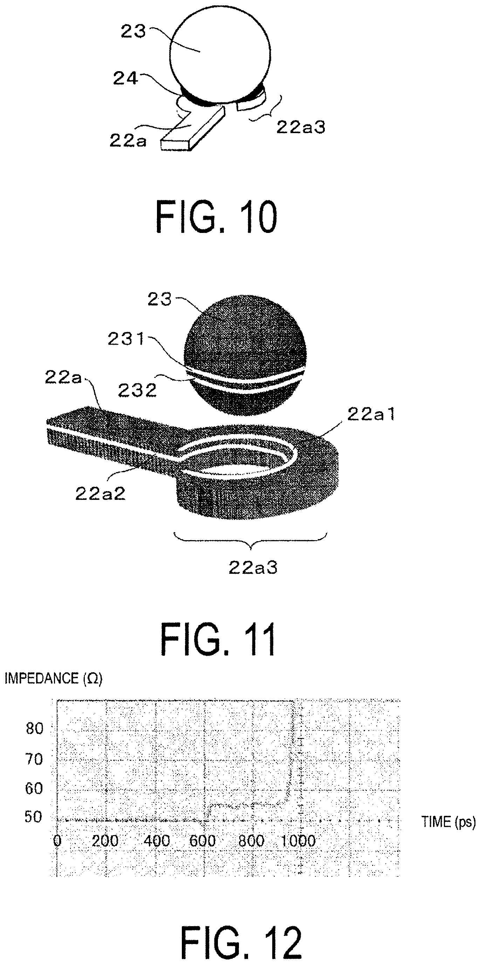

FIG. 10 illustrates a state in which the support body 23 and the first signal wiring conductor 22a illustrated in FIG. 9 are connected to each other, and FIG. 11 illustrates a state in which the support body and the first signal wiring conductor illustrated in FIG. 9 are separated from each other. FIG. 11 illustrates the first region 22a1 and the second region 22a2 of the first signal wiring conductor 22a and the third region 231 and the fourth region 232 of the support body 23 when the first signal wiring conductor 22a including the hook-shaped portion 22a3 and the support body 23 are used as illustrated in FIG. 10.

As illustrated in FIG. 11, the first region 22a1 of the first signal wiring conductor 22a is located on an inner peripheral side on the upper surface of the hook-shaped portion 22a3. When the support body 23 is connected to the hook-shaped portion 22a3, a region in the vicinity of a contact portion with the inner peripheral side of the hook-shaped portion 22a3 becomes the third region 231. That is, the first region 22a1 and the third region 231 confront each other.

In FIG. 11, in the hook-shaped portion 22a3, the first region 22a1 located on the upper surface and the second region 22a2 located on the inner side surface are illustrated separated from each other for convenience of description. However, actually, in the hook-shaped portion 22a3, the first region 22a1 and the second region 22a2 are continuous. That is, the first region 22a1 is located on the upper surface of the hook-shaped portion 22a3, and the second region 22a2 is located on the inner side surface of the hook-shaped portion 22a3 continuously with the first region 22a1. In the support body 23, a region adjacent to the second region 22a2 is the fourth region 232. In FIG. 11, the third region 231 and the fourth region 232 of the support body 23 are merely indicated by white lines for convenience of description. Actually, the third region 231 and the fourth region 232 are regions having widths in the vicinity of the corresponding white lines.

The current (electrical signal) has a property of selecting a short path. For this reason, when the first signal wiring conductor 22a includes the hook-shaped portion 22a3, the electrical signal circulates around the inner side surface of the hook-shaped portion 22a3. Solder can be mounted on the upper surface of the hook-shaped portion 22a3, and the first fixing member pad 24a need not be provided.

Since the width of the hook-shaped portion 22a3 decreases toward the distal end thereof, the electrical signal can naturally select a path with a smaller impedance step. Specifically, since the width of the hook-shaped portion 22a3 decreases toward the distal end, the impedance increases from the root to the distal end of the hook-shaped portion 22a3. For this reason, the electrical signal moves to the support body 23 from a portion where the impedances match in the hook-shaped portion 22a3.

FIG. 12 is a graph showing a simulation result when the first signal wiring conductor 22a and the support body 23 illustrated in FIG. 10 are used. In the simulation, two boards whose wiring impedance was actually 54 Ω were connected to each other by a copper support body (a spherical body having a diameter of 0.5 mm), and measurement was performed along the wiring from one board end by time domain reflectometry (TDR). At a relative permittivity of 4.1 and a dielectric loss tangent of 0.01, the width W1 was 350 µm, the width W2 was 150 µm, and the width W3 was 100 µm. The values of the widths W1, W2, and W3 are not limited and may be set appropriately in accordance with characteristics of a material.

In the case where the first signal wiring conductor 22a and the support body 23 illustrated in FIG. 10 are used, since the width of the hook-shaped portion 22a3 decreases toward the distal end as described above, the electrical signal naturally selects a path with a smaller impedance step. For this reason, as shown in FIG. 12, it can be seen that the impedance step in the BGA connection is smaller and a substantially constant impedance is maintained.

As described above, in the wiring board 2 according to one embodiment, the fourth region 232 adjacent to the second region 22a2 of the first signal wiring conductor 22a is not covered with the first fixing member 24. Therefore, the wiring board 2 according to one embodiment can reduce reflection of high-frequency signals at the connection portion between the first signal wiring conductor 22a and the first fixing member 24. As a result, the wiring board 2 according to one embodiment can efficiently transmit high-frequency signals.

An electronic component mounting structure according to the present disclosure will be described with reference to FIG. 1. As illustrated in FIG. 1, an electronic component mounting structure 1 according to one embodiment of the present disclosure includes the wiring board 2 according to the above-described embodiment and the electronic component 3. Specifically, the electronic component mounting structure 1 has a structure in which the wiring board 2 and the electronic component 3 are connected to each other via the support body 23 provided on the wiring board 2.

The electronic component 3 is not limited as long as it is generally an electronic component mounted on the wiring board. Examples of the electronic component 3 may include a semiconductor integrated circuit element, an optoelectronic element, a wireless receiving/transmitting element, and a photoelectric conversion element.

As illustrated in FIG. 1, the electronic component 3 may include a second signal wiring conductor 32a. The second signal wiring conductor 32a and the support body 23 included in the wiring board 2 are fixed by a second fixing member 34. Like the first fixing member 24, the second fixing member 34 is also made of metal such as solder, gold, or silver.

As illustrated in FIG. 1, the second signal wiring conductor 32a includes a fifth region 32a1 and the sixth region 32a2 extending continuously from the fifth region 32a1. As illustrated in FIG. 2, the conductor located on the surface of the support body 23 further includes a seventh region 233 and the eighth region 234. The seventh region 233 of the support body 23 confronts the fifth region 32a1 of the second signal wiring conductor 32a. The eighth region 234 of the support body 23 is located adjacent to the sixth region 32a2 of the second signal wiring conductor 32a.

In the support body 23 connected to the second signal wiring conductor 32a, the second fixing member 34 is located at a place other than the eighth region 234 included on the surface of the support body 23. That is, the second fixing member 34 is not present from the sixth region 32a2 of the second signal wiring conductor 32a to the eighth region 234 included on the surface of the support body 23; thus, the regions are exposed. In this way, the second fixing member 34 is not present, so that reflection of high-frequency signals is reduced and the high-frequency signals can be efficiently transmitted to the electronic component 3. The eighth region 234 can be formed by the same method as the fourth region 232 described above.

The second fixing members 34 are preferably present at symmetrical positions with respect to the eighth region 234 in a plan view. The presence of the second fixing members 34 at symmetrical positions with respect to the eighth region 234 can help prevent the support body 23 from being pulled by the surface tension of the second fixing members 34 and being inclined.

A width of the eighth region 234 may be, for example, equal to or greater than 1/3 of a width of the sixth region 32a2. When the width of the eighth region 234 is equal to or greater than 1/3 of the width of the sixth region 32a2, reflection of high-frequency signals is sufficiently reduced, and the high-frequency signals can be transmitted more efficiently to the electronic component 3. The width of the eighth region 234 is preferably equal to or greater than the width of the sixth region 32a2.

Although not illustrated, the second fixing member 34 may be located on a second fixing member pad on a surface of the electronic component 3 (a surface on which the second signal wiring conductor 32a is located). In this case, the second fixing member pad and the fifth region 32a1 of the second signal wiring conductor 32a are preferably located away from each other. In this way, when the second fixing member pad and the fifth region 32a1 are located away from each other, wetting and spreading of metal such as solder on the support body 23 can be reduced. The second fixing member pad and the fifth region 32a1 may be connected to each other by a conductor having a width smaller than a width of the second fixing member pad and a width of the fifth region 32a1.

Although not illustrated, a thin film layer may be located between the fifth region 32a1 of the second signal wiring conductor 32a and the seventh region 233 of the support body 23. The thin film layer is the same as, and/or similar to, the thin film layer 25 described above, and the detailed description thereof will be omitted. When such a thin film layer is located, oxidation of the conductors located in the fifth region 32a1 and the seventh region 233 can be reduced.

### REFERENCE SIGNS

1 Electronic component mounting structure
2 Wiring board
21 Base
22 Wiring conductor
22a First signal wiring conductor
22a1 First region
22a2 Second region
22a3 Hook-shaped portion
23 Support body
231 Third region
232 Fourth region
233 Seventh region
234 Eighth region
24 First fixing member
25 Thin film layer
3 Electronic component
32a Second signal wiring conductor
32a1 Fifth region
32a2 Sixth region
34 Second fixing member

## Claims

1. A wiring board comprising:
a base;
a wiring conductor located on a surface of the base;
a support body comprising a conductor on a surface of the support body; and
a first fixing member connecting the wiring conductor and the support body, wherein the wiring conductor comprises a first signal wiring conductor comprising a first region confronting the support body and a second region extending continuously from the first region,
the conductor of the support body comprises a third region confronting the first region of the first signal wiring conductor and a fourth region adjacent to the second region of the first signal wiring conductor, and
the first fixing member is located at a place other than the fourth region.

2. The wiring board according to claim 1, wherein a width of the fourth region is equal to or greater than 1/3 of a width of the second region of the first signal wiring conductor.

3. The wiring board according to claim 1 or 2, wherein a thin film layer having a thickness of 15 µm or less is located between the first region of the first signal wiring conductor and the third region of the support body.

4. The wiring board according to any one of claims 1 to 3, wherein
the wiring conductor further comprises a first fixing member pad on which the first fixing member is located, and
in a plane perspective, the first region and the first fixing member pad are located away from each other, or the first region and the first fixing member pad are connected to each other by a conductor having a width smaller than a width of the first region and a width of the first fixing member pad.

5. The wiring board according to any one of claims 1 to 4, wherein, in a plan view, the first fixing member is present at each of symmetrical positions with respect to the fourth region.

6. The wiring board according to any one of claims 1 to 5, wherein the support body is a spherical body having a surface on at least part of which the conductor is located.

7. The wiring board according to claim 6, wherein the support body is a spherical body on which the conductor having a width of 70% or more and 130% or less of a width of the second region of the first signal wiring conductor is located in the fourth region.

8. The wiring board according to claim 6, wherein the first signal wiring conductor comprises a hook-shaped portion at a portion connected to the support body, and when the hook-shaped portion is seen in a plan view, a width of the hook-shaped portion decreases toward a distal end of the hook-shaped portion.

9. The wiring board according to any one of claims 1 to 5, wherein the support body is a tubular body, and the first fixing member is located in at least a part of a hollow portion of the tubular body.

10. The wiring board according to any one of claims 1 to 5, wherein the support body is an annular body, and an outer peripheral surface of the annular body and the first signal wiring conductor are connected to each other by the first fixing member.

11. The wiring board according to any one of claims 1 to 5, wherein the support body is a columnar body, and the columnar body is located in such a manner that a height direction of the columnar body is parallel to an extension direction of the first signal wiring conductor.

12. An electronic component mounting structure comprising:
the wiring board according to any one of claims 1 to 11; and
an electronic component.

13. The electronic component mounting structure according to claim 12, wherein
the electronic component comprises a second signal wiring conductor connected to the support body comprised on the wiring board by a second fixing member,
the second signal wiring conductor comprises a fifth region confronting the support body and a sixth extending continuously from the fifth region,
the conductor of the support body comprises a seventh region confronting the fifth region of the second signal wiring conductor and an eighth region adjacent to the sixth region of the second signal wiring conductor, and
the second fixing member is located in a region other than the eighth region on a surface of the support body.
